# EUROPÄISCHE PATENTANMELDUNG

(11) **EP 4 013 188 A1**
(43) Veröffentlichungstag der Anmeldung: **15.06.2022**
(21) Anmeldenummer: 21020412.9
(22) Anmeldetag: 12.08.2021
(51) Int. Cl.: H05B 3/84, H05B 3/20, H05K 3/14, H05K 3/38, H05K 1/02, H05K 1/03, H05B 3/36

(54) **LEITFÄHIGE FOLIE, VERFAHREN ZUM HERSTELLEN DERSELBEN UND VERWENDUNG**

(30) Priorität: 11.12.2020 DE 102020007607
(71) Anmelder: Giesecke+Devrient Currency Technology GmbH, 81677 München (DE)
(72) Erfinder: Gottschling, Kerstin, 82024 Taufkirchen (DE); Hunger, Christoph, 83734 Hausham (DE); Lenssen, Daniel, 81829 München (DE)
(74) Vertreter: Giesecke + Devrient IP

(57) **Zusammenfassung**

Die Erfindung betrifft eine leitfähige Folie, umfassend ein Substrat, auf dessen Hauptfläche in der Reihenfolge eine Primerschicht und darauffolgend eine im Wesentlichen leitfähige Struktur in Form eines dichtmaschigen, zusammenhängenden Netzes mit einer Vielzahl von Öffnungen unterschiedlicher geometrischer Form ausgebildet sind

## Beschreibung

Die Erfindung betrifft eine leitfähige Folie, ein Verfahren zum Herstellen derselben und eine Verwendung.

Leitfähige Folien, die z.B. als Heizelemente für Windschutzscheiben von Fahrzeugen geeignet sind, wurden im Stand der Technik beschrieben, siehe z.B. die EP 2764996 B1, die EP 2284134 B1 und die WO 2016/192858 A1.

Gemäß der WO 2016/192858 A1 erfolgt die Herstellung einer leitfähigen Folie auf Grundlage eines mehrstufigen Verfahrens, bei dem zunächst auf einem Trägersubstrat eine abwaschbare Beschichtung aufgebracht wird, die beim Trocknen zahlreiche Risse in Form eines dichtmaschigen, zusammenhängenden Netzes ausbildet. Anschließend erfolgt das Bedampfen mit Metall, gefolgt von einem Entfernen der mit Rissen versehenen, abwaschbaren Beschichtung in einem Waschschritt. Das erhaltene Erzeugnis ist so beschaffen, dass es oberhalb des Trägersubstrats eine leitfähige Metallisierung in Form eines dichtmaschigen, zusammenhängenden Netzes aufweist.

In der Praxis hat sich gezeigt, dass insbesondere im Falle des Aufbringens der abwaschbaren Beschichtung auf ein auf Polyethylenterephthalat (PET) basierendes Trägersubstrat beim Trocknen eine ausgeprägte Anisotropie der Riss-Bildung feststellbar ist. Dies führt bei der erhaltenen leitfähigen Folie zu einer starken Anisotropie, z.B. mit Bezug auf die Wärmeverteilung im Falle von Heizanwendungen. Zudem ist die Übertragung des Herstellungsverfahrens ausgehend von auf Polyethylenterephthalat (PET) basierenden Trägersubstraten auf andere Trägersubstrate, z.B. Polycarbonat (PC), Polymethylmethacrylat (PMMA), thermoplastisches Polyurethan (TPU), Glas oder dergleichen, schwierig, sodass die Rezeptur der abwaschbaren Beschichtung für jede Oberfläche je nach den Eigenschaften des heranzuziehenden Trägersubstrats individuell entwickelt werden muss.

Der vorliegenden Erfindung liegt die Aufgabe zugrunde, die Herstellung der im Stand der Technik bekannten leitfähigen Folie zu verbessern. Insbesondere soll eine leitfähige Folie bereitgestellt werden, die trotz des Heranziehens ein und derselben stofflichen Zusammensetzung für die Bereitstellung der abwaschbaren, Riss-bildenden Beschichtung, und zwar unabhängig von der materiellen Wahl des Trägersubstrats, verglichen mit den im Stand der Technik bekannten leifähigen Folien eine unterdrückte Anisotropie aufweist.

Diese Aufgabe wird durch die in den unabhängigen Ansprüchen definierten Merkmalskombinationen gelöst. Weiterbildungen der Erfindung sind Gegenstand der Unteransprüche.

### Zusammenfassung der Erfindung

1. (Erster Aspekt der Erfindung) Leitfähige Folie, umfassend ein Substrat, auf dessen Hauptfläche in der Reihenfolge eine Primerschicht und darauffolgend eine im Wesentlichen leitfähige Struktur in Form eines dichtmaschigen, zusammenhängenden Netzes mit einer Vielzahl von Öffnungen unterschiedlicher geometrischer Form ausgebildet sind.
2. (Bevorzugte Ausgestaltung) Leitfähige Folie nach Absatz 1, wobei die Primerschicht auf einer Zusammensetzung basiert, die im Wesentlichen ein Bindemittel und organisches Lösungsmittel und/oder Wasser enthält.
3. (Bevorzugte Ausgestaltung) Leitfähige Folie nach Absatz 2, wobei das Bindemittel von der Gruppe bestehend aus Methacrylaten, Styrolverbindungen, Acrylsäureesterverbindungen, Polyesterverbindungen, insbesondere ionische Polyesterverbindungen, Polyurethan und Gemischen zweier oder mehrerer der vorstehend genannten Elemente gewählt ist.
4. (Bevorzugte Ausgestaltung) Leitfähige Folie nach Absatz 2 oder 3, wobei die Zusammensetzung zusätzlich einen Hilfsstoff enthält, der von der Gruppe bestehend aus Entschäumern, Benetzungsadditiven, Verlaufsadditiven, Koaleszenzadditiven, Additiven zur Steuerung der Oberflächenenergie und Gemischen zweier oder mehrerer der vorstehend genannten Elemente gewählt ist.
5. (Bevorzugte Ausgestaltung) Leitfähige Folie nach einem der Absätze 1 bis 4, wobei die Schichtdicke der Primerschicht in einem Bereich von 0,1 µm bis 10 µm liegt.
6. (Bevorzugte Ausgestaltung) Leitfähige Folie nach einem der Absätze 1 bis 5, wobei die leitfähige Struktur auf einer leitfähigen Metallisierung basiert, die von der Gruppe bestehend aus Kupfer, Gold, Aluminium, Silber, einer Legierung zweier oder mehrerer der vorstehend genannten Elemente und einem Mehrlagensystem zweier oder mehrerer der vorstehend genannten Elemente gewählt ist.
7. (Bevorzugte Ausgestaltung) Leitfähige Folie nach einem der Absätze 1 bis 6, wobei die leitfähige Struktur auf einer Mehrschichtanordnung basiert, die zusätzlich zur leitfähigen Metallisierung einseitig oder beidseitig eine zusätzliche Schicht zur Einstellung einer definierten Farbe oder zur Reduktion des Glanzes aufweist.
8. (Bevorzugte Ausgestaltung) Leitfähige Folie nach Absatz 7, wobei die zusätzliche Schicht zur Einstellung einer definierten Farbe oder zur Reduktion des Glanzes von der Gruppe bestehend aus einem Metall, vorzugsweise Chrom, Titan oder Nickel, einer Metalloxidschicht, vorzugsweise eine auf einem unterstöchiometrischen, schwarzen Aluminiumoxid, Chromoxid oder Kupferoxid basierende Metalloxidschicht, einer schwarzen, einen Farbkippeffekt aufweisenden PVD-Beschichtung mit Reflektor/Dielektrikum/ Absorber-Aufbau, Chromschwarz, Nickelschwarz, einer Metallsulfidschicht, einem auf einem Farblack oder einem Pigmentlack basierenden Überdruck, einer durch eine Nanostrukturierung bzw. Mottenaugenstruktur gebildete Antireflexionsschicht und einer Kombination zweier oder mehrerer der vorstehend genannten Elemente gewählt ist.
9. (Bevorzugte Ausgestaltung) Leitfähige Folie nach einem der Absätze 1 bis 8, wobei die Folie zusätzlich eine die leitfähige Struktur einebnende Schicht und eine Klebschicht aufweist.
10. (Bevorzugte Ausgestaltung) Leitfähige Folie nach einem der Absätze 1 bis 9, wobei das Substrat von der Gruppe bestehend aus Polyethylenterephthalat (PET), Polycarbonat (PC), Polymethylmethacrylat (PMMA), thermoplastischem Polyurethan (TPU) und Glas gewählt ist und bevorzugt ein transparentes Substrat ist.
11. (Bevorzugte Ausgestaltung) Leitfähige Folie nach einem der Absätze 1 bis 10, wobei die leitfähige Folie transparent ist.
12. (Zweiter Aspekt der Erfindung) Verfahren zum Herstellen einer leitfähigen Folie nach einem der Absätze 1 bis 11, umfassend die folgenden Schritte:
   - das Bereitstellen eines Substrats;
   - das Versehen einer Hauptfläche des Substrats mit einer Primerschicht;
   - das Aufbringen einer Riss-bildenden Beschichtung auf die Primerschicht und Trocknen der Riss-bildenden Beschichtung, wobei die Beschichtung beim Trocknen zahlreiche Risse in Form eines dichtmaschigen, zusammenhängenden Netzes ausbildet;
   - das Aufbringen einer leitfähigen Struktur;
   - das Entfernen der mit Rissen versehenen Beschichtung zusammen mit der oberhalb der Beschichtung vorliegenden leitfähigen Struktur, sodass das erhaltene Substrat so beschaffen ist, dass auf seiner mit einer Primerschicht versehenen Hauptfläche die leitfähige Struktur in Form eines dichtmaschigen, zusammenhängenden Netzes mit einer Vielzahl von Öffnungen unterschiedlicher geometrischer Form ausgebildet ist.
13. (Dritter Aspekt der Erfindung) Verwendung der leitfähigen Folie nach einem der Absätze 1 bis 11 als Heizfolie, insbesondere in der Windschutzscheibe eines Fahrzeugs, in sonstigen Fenstern oder in der Gebäudeverglasung, sowie zur Stromeinkopplung ohne sichtbare Zuleitungen, z.B. zur Verwendung in LED-Folien, in Solarzellen, in Smart-Glass-Anwendungen, in OLEDs oder in Touch Panels.

### Ausführliche Beschreibung der Erfindung

Die vorliegende Erfindung basiert auf der aus der WO 2016/192858 A1 bekannten Technologie zur Feinstrukturierung von Metallisierungen, auf deren Grundlage elektrische Vorrichtungen, z.B. Heizfolien zur Verwendung in der Windschutzscheibe eines Fahrzeugs, bereitgestellt werden können. Zur Technologie gehört u.a. die Verwendung einer Riss-bildenden Beschichtung, bevorzugt eine Dispersion oder eine Lösung eines Polymers. Die Riss-bildende Beschichtung wird auf das Substrat aufgebracht, z.B. mittels Aufdrucken, sodass ein dünner Film erzeugt wird, der während des Trocknens Risse in Form eines dichtmaschigen, zusammenhängenden Netzes ausbildet. Anschließend erfolgt das Bedampfen mit Metall, gefolgt von einem Entfernen der mit Rissen versehenen, abwaschbaren Beschichtung in einem Waschschritt. Das erhaltene Erzeugnis ist so beschaffen, dass es oberhalb des transparenten Substrats eine leitfähige Struktur in Form eines dichtmaschigen, zusammenhängenden Netzes aufweist.

Der vorliegenden Erfindung liegt die Erkenntnis zugrunde, dass mittels des Versehens des Trägersubstrats mit einer Primerschicht ein isotropes metallisches Netzwerk erhältlich ist, und zwar unabhängig von der stofflichen Zusammensetzung für die Bereitstellung der abwaschbaren, Riss-bildenden Beschichtung und unabhängig von der materiellen Wahl des Trägersubstrats. Die Anwendbarkeit des aus der WO 2016/192858 A1 bekannten Herstellungsverfahrens nicht allein auf ein auf Polyethylenterephthalat (PET) basierendes Trägersubstrat, sondern auf jegliche Trägersubstrate, z.B. Polycarbonat (PC), Polymethylmethacrylat (PMMA), thermoplastisches Polyurethan (TPU), Glas oder dergleichen, ist mittels der vorliegenden Erfindung gewährleistet, ohne dass die stoffliche Rezeptur der abwaschbaren, Riss-bildenden Beschichtung für jede Oberfläche je nach Abhängigkeit des heranzuziehenden Trägersubstrats individuell angepasst werden muss. Darüber hinaus weist die erfindungsgemäße leitfähige Folie infolge ihres isotropen metallischen Netzwerks eine hervorragende richtungsunabhängige elektrische Leifähigkeit sowie Wärmeleitfähigkeit auf.

Es wird bevorzugt, dass die Primerschicht auf einer Zusammensetzung basiert, die im Wesentlichen ein Bindemittel und organisches Lösungsmittel und/oder Wasser enthält. Die Zusammensetzung wird insbesondere so gewählt, dass das Bindemittel von der Gruppe bestehend aus Methacrylaten, Styrolverbindungen, Acrylsäureesterverbindungen, Polyesterverbindungen, insbesondere ionische Polyesterverbindungen, Polyurethan und Gemischen zweier oder mehrerer der vorstehend genannten Elemente gewählt ist. Weiter im Besonderen kann die Zusammensetzung zusätzlich einen Hilfsstoff enthalten, der von der Gruppe bestehend aus Entschäumern, Benetzungsadditiven, Verlaufsadditiven, Koaleszenzadditiven, Additiven zur Steuerung der Oberflächenenergie und Gemischen zweier oder mehrerer der vorstehend genannten Elemente gewählt ist.

Alternativ kann die Primerschicht auf einem 100%igen UV-Lacksystem oder einem reaktiven System, wie etwa einem Einkomponentensystem oder einem Zweikomponentensystem, basieren.

Die Schichtdicke der Primerschicht wird vorzugsweise so eingestellt, dass sie in einem Bereich von 0,1 µm bis 10 µm liegt. Eine besonders bevorzugte Schichtdicke der Primerschicht beträgt etwa 1 µm.

Für das Erzielen einer vorteilhaften Leitfähigkeit wird die leitfähige Struktur auf Grundlage eines leitfähigen Metalls, vorzugsweise durch eine Kupfer-, Gold-, Aluminium- oder Silberschicht, realisiert.

Bei Bedarf kann die erfindungsgemäße leitfähige Folie zusätzlich eine die leitfähige Struktur einebnende, vorzugsweise transparente, Schicht und eine vorzugsweise transparente Klebschicht aufweisen. Mit Bezug auf die die leitfähige Metallisierung einebnende Schicht eignet sich z.B. ein UVhärtender oder wärmehärtender Primerlack. Das so erhaltene Erzeugnis kann anschließend mit einer Klebschicht versehen werden, die z.B. auf der der leitfähigen Metallisierung gegenüber liegenden Seite des Substrats angeordnet ist. Die Klebschicht kann alternativ oberhalb der die leitfähige Metallisierung einebnenden Beschichtung angeordnet werden. Als Klebschicht eignet sich z.B. ein Heißsiegellack. Gemäß einer speziellen Variante kann die eingesetzte Klebschicht, z.B. ein Heißsiegellack, mit der für das Einebnen der leitfähigen Metallisierung verwendeten transparenten Beschichtung identisch sein.

Weiterhin wird bevorzugt, dass die die leitfähige Struktur auf einer Mehrschichtanordnung basiert, die zusätzlich zur leitfähigen Metallisierung einseitig oder beidseitig eine zusätzliche Schicht zur Einstellung einer definierten Farbe oder zur Reduktion des Glanzes aufweist. Die zusätzliche Schicht zur Einstellung einer definierten Farbe oder zur Reduktion des Glanzes wird insbesondere von der Gruppe bestehend aus einer Metalloxidschicht, vorzugsweise eine auf einem unterstöchiometrischen, schwarzen Aluminiumoxid oder Kupferoxid basierende Metalloxidschicht, einer schwarzen, einen Farbkippeffekt aufweisenden PVD-Beschichtung mit Reflektor/Dielektrikum/ Absorber-Aufbau, Chromschwarz, Nickelschwarz, einer Metallsulfidschicht, einem auf einem Farblack oder einem Pigmentlack basierenden Überdruck, einer durch eine Nanostrukturierung bzw. Mottenaugenstruktur gebildete Antireflexionsschicht und einer Kombination zweier oder mehrerer der vorstehend genannten Elemente gewählt.

Die vorliegende Erfindung betrifft weiterhin den Aspekt des Herstellens einer leitfähigen Folie, umfassend die folgenden Schritte:
- das Bereitstellen eines Substrats;
- das Versehen einer Hauptfläche des Substrats mit einer Primerschicht;
- das Aufbringen einer Riss-bildenden Beschichtung auf die Primerschicht und Trocknen der Riss-bildenden Beschichtung, wobei die Beschichtung beim Trocknen zahlreiche Risse in Form eines dichtmaschigen, zusammenhängenden Netzes ausbildet;
- das Aufbringen einer leitfähigen Struktur;
- das Entfernen der mit Rissen versehenen Beschichtung zusammen mit der oberhalb der Beschichtung vorliegenden leitfähigen Struktur, sodass das erhaltene Substrat so beschaffen ist, dass auf seiner mit einer Primerschicht versehenen Hauptfläche die leitfähige Struktur in Form eines dichtmaschigen, zusammenhängenden Netzes mit einer Vielzahl von Öffnungen unterschiedlicher geometrischer Form ausgebildet ist.

Das erfindungsgemäße Herstellungsverfahren ist an die in der WO 2016/192858 A1 beschriebene Herstellung angelehnt.

Erfindungsgemäß wird als Riss-bildende Beschichtung bevorzugt eine Dispersion, weiter bevorzugt eine kolloidale Dispersion eingesetzt. Weitere Optionen finden sich beispielsweise in der WO 2014/136039 A1. Darüber hinaus kann die Riss-bildende Beschichtung auf einem in Lösung vorliegenden Polymer basieren. Die Polymer-Lösung wird auf das Substrat aufgebracht, z.B. mittels Aufdrucken, sodass ein dünner Polymerfilm erzeugt wird. Der dünne Polymerfilm bildet während des Trocknens Risse aus.

Infolge des Heranziehens einer Primerschicht verläuft die Riss-Bildung unabhängig von der materiellen Wahl des Substrats und unabhängig von der stofflichen Rezeptur der Riss-bildenden Beschichtung. Dabei liegen die am Ende des Herstellungsverfahrens erzielbaren Linienstärken z.B. im Falle von Silber im Bereich von 0,1 µm bis 50 µm, bevorzugt im Bereich von 1µm bis 30µm, wobei die Linien in der Regel so fein sind, dass sie erst beim Einsatz einer Lupe als Linien erkennbar sind. In der Fläche löst das menschliche Auge die einzelnen Linien nicht auf, man erkennt aber sowohl im Auflicht (bzw. Reflexion), als auch im Durchlicht (bzw. Transmission) einen Unterschied gegenüber der unbehandelten bzw. bloßen Folie. Da die feinen Linien ein unregelmäßiges, zusammenhängendes Netz bilden, können unerwünschte Beugungseffekte minimiert werden. Durch Variation der Insel-Größe und der Riss-Breite kann das Reflexionsvermögen bzw. die Licht-Durchlässigkeit in geeigneter Weise eingestellt werden.

Das Verfahren zum Entfernen der mit Rissen versehenen Beschichtung erfolgt mit Vorteil mittels Auflösen mit einem geeigneten Lösungsmittel. Die Wahl des Lösungsmittels erfolgt zweckmäßigerweise in Abstimmung auf die Beschichtung. Typischerweise können die folgenden Lösungsmittel verwendet werden: Methylacetat, Ethylacetat, Propylacetat, Butylacetat, Methoxypropylacetat, Aceton, Methylethylketon, Methylisobutylketon, Cyclopentanon, Cyclohexanon, Methylenchlorid, Chloroform, Toluol, Xylol, Methanol, Ethanol, 2-Propanol. Weiterhin können Acetale oder Gemische der vorstehend genannten Lösungsmittel verwendet werden. Alternativ kann auch ein Ablösen der Riss-bildenden Beschichtung durch Unterwanderung erfolgen. In diesem Fall können neben den genannten Lösungsmitteln auch wässrige Lösungen, Mischungen von Lösungsmitteln und Wasser, ggf. mit Tensiden, ggf. mit Entschäumern und sonstigen Additiven zum Einsatz kommen. Die Ablösung bzw. Auflösung der mit Rissen versehenen Beschichtung kann auch durch Spritzdüsen oder auch mechanisch durch Bürsten, Walzen oder durch Filze unterstützt werden.

Die leitfähige Struktur, insbesondere Metallisierung, in Form eines dichtmaschigen, zusammenhängenden Netzes zeigt eine elektrische Leitfähigkeit sowie eine optische Transmission, die mit einer vollflächigen ITO-Schicht vergleichbar ist. Dabei können die feinen metallischen Linien in Kombination mit üblichen Prägelacken, üblichen Primer-Zusammensetzungen und üblichen Heißsiegellacken eingesetzt werden.

Die erfindungsgemäße leitfähige Folie eignet sich insbesondere zur Anwendung in elektrischen Vorrichtungen, z.B. als Heizfolie zur Verwendung in der Windschutzscheibe eines Fahrzeugs, in sonstigen Fenstern oder in der Gebäudeverglasung, sowie zur Stromeinkopplung ohne sichtbare Zuleitungen, z.B. zur Verwendung in LED-Folien, in Solarzellen, in Smart-Glass-Anwendungen, in OLEDs oder in Touch Panels.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:
- Figuren 1 - 4: die einzelnen Herstellungsschritte für das Erhalten einer leitfähigen Folie gemäß einem ersten Ausführungsbeispiel; und

- Figur 5: die leitfähige Folie gemäß dem ersten Ausführungsbeispiel bei der Betrachtung in Draufsicht.

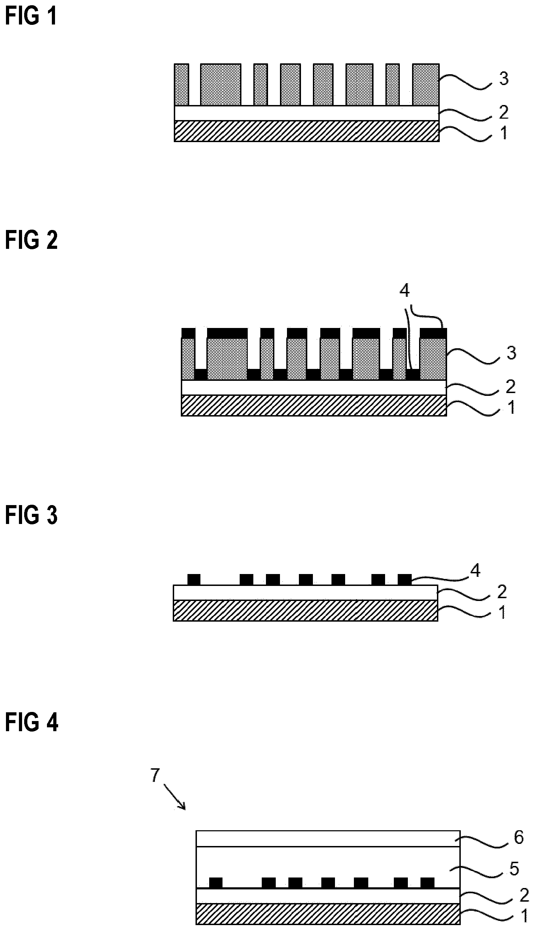

Die Figuren 1 bis 4 veranschaulichen die einzelnen Herstellungsschritte für das Erhalten einer leitfähigen Folie gemäß einem ersten Ausführungsbeispiel.

Gemäß den Figuren 1 und 2 erfolgt zunächst das Bereitstellen eines Substrats 1, im vorliegenden Fall eine Polycarbonat(PC)-Folie, das Versehen des Substrats 1 mit einer Primerschicht 2 und darauffolgend das Aufbringen einer Riss-bildenden Beschichtung 3. Die Primerschicht 2 weist im vorliegenden Beispiel eine Schichtdicke von etwa 1 µm auf. Die Riss-bildende Beschichtung 3 basiert z.B. auf anorganischen Dispersionen oder auf Acrylharz-Dispersionen. Das Aufbringen der Riss-bildenden Beschichtung 3 erfolgt bevorzugt drucktechnisch, z.B. mittels Tiefdruck, Flexodruck, Slot-Die coating, Siebdruck oder mittels eines Inkjet-Verfahrens. Die Riss-bildende Beschichtung 3 bildet beim Trocknen zahlreiche Risse in Form eines dichtmaschigen, zusammenhängenden Netzes aus. Das Netz ist isotrop, d.h. richtungsunabhängig, ausgebildet.

In einem weiteren Schritt erfolgt das Aufbringen einer leitfähigen Schicht 4, im vorliegenden Fall eine Cu-Schicht (siehe Figur 2). Die Cu- Schicht 4 wird sowohl oberhalb der mit Rissen versehenen Beschichtung 3 als auch innerhalb der Risse der Beschichtung 3 abgeschieden.

Gemäß der Figur 3 erfolgt anschließend das Entfernen der mit Rissen versehenen Beschichtung 3 inklusive der oberhalb der Beschichtung 3 vorhandenen Schicht 4 in einem Waschschritt. Das Waschen erfolgt mittels Auflösen mit einem geeigneten Lösungsmittel, z.B. Methylacetat. Auf der transparenten Primerschicht 2 verbleibt eine transparente, leitfähige Metallisierung in Form eines dichtmaschigen, zusammenhängenden Netzes.

Gemäß der Figur 4 kann optional das Aufbringen eines transparenten, einebnenden Lacks 5 erfolgen. Eine gegebenenfalls vorhandene Klebschicht 6, z.B. eine Heißsiegellackschicht, dient für das Aufbringen der leitfähigen Folie 7 z.B. auf die Windschutzscheibe eines Fahrzeugs.

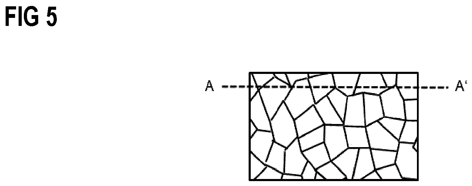

Die Figur 5 zeigt die leitfähige Metallisierung in Form eines dichtmaschigen, zusammenhängenden Netzes schematisch in Draufsicht in vergrößerter Darstellung (die Figur 4 zeigt dabei eine Querschnittansicht entlang der gestrichelten Linie A-A').

## Patentansprüche

1. Leitfähige Folie, umfassend ein Substrat, auf dessen Hauptfläche in der Reihenfolge eine Primerschicht und darauffolgend eine im Wesentlichen leitfähige Struktur in Form eines dichtmaschigen, zusammenhängenden Netzes mit einer Vielzahl von Öffnungen unterschiedlicher geometrischer Form ausgebildet sind.

2. Leitfähige Folie nach Anspruch 1, wobei die Primerschicht auf einer Zusammensetzung basiert, die im Wesentlichen ein Bindemittel und organisches Lösungsmittel und/oder Wasser enthält.

3. Leitfähige Folie nach Anspruch 2, wobei das Bindemittel von der Gruppe bestehend aus Methacrylaten, Styrolverbindungen, Acrylsäureesterverbindungen, Polyesterverbindungen, insbesondere ionische Polyesterverbindungen, Polyurethan und Gemischen zweier oder mehrerer der vorstehend genannten Elemente gewählt ist.

4. Leitfähige Folie nach Anspruch 2 oder 3, wobei die Zusammensetzung zusätzlich einen Hilfsstoff enthält, der von der Gruppe bestehend aus Entschäumern, Benetzungsadditiven, Verlaufsadditiven, Koaleszenzadditiven, Additiven zur Steuerung der Oberflächenenergie und Gemischen zweier oder mehrerer der vorstehend genannten Elemente gewählt ist.

5. Leitfähige Folie nach einem der Ansprüche 1 bis 4, wobei die Schichtdicke der Primerschicht in einem Bereich von 0,1 µm bis 10 µm liegt.

6. Leitfähige Folie nach einem der Ansprüche 1 bis 5, wobei die leitfähige Struktur auf einer leitfähigen Metallisierung basiert, die von der Gruppe bestehend aus Kupfer, Gold, Aluminium, Silber, einer Legierung zweier oder mehrerer der vorstehend genannten Elemente und einem Mehrlagensystem zweier oder mehrerer der vorstehend genannten Elemente gewählt ist.

7. Leitfähige Folie nach einem der Ansprüche 1 bis 6, wobei die leitfähige Struktur auf einer Mehrschichtanordnung basiert, die zusätzlich zur leitfähigen Metallisierung einseitig oder beidseitig eine zusätzliche Schicht zur Einstellung einer definierten Farbe oder zur Reduktion des Glanzes aufweist.

8. Leitfähige Folie nach Anspruch 7, wobei die zusätzliche Schicht zur Einstellung einer definierten Farbe oder zur Reduktion des Glanzes von der Gruppe bestehend aus einem Metall, vorzugsweise Chrom, Titan oder Nickel, einer Metalloxidschicht, vorzugsweise eine auf einem unterstöchiometrischen, schwarzen Aluminiumoxid, Chromoxid oder Kupferoxid basierende Metalloxidschicht, einer schwarzen, einen Farbkippeffekt aufweisenden PVD-Beschichtung mit Reflektor/Dielektrikum/ Absorber-Aufbau, Chromschwarz, Nickelschwarz, einer Metallsulfidschicht, einem auf einem Farblack oder einem Pigmentlack basierenden Überdruck, einer durch eine Nanostrukturierung bzw. Mottenaugenstruktur gebildete Antireflexionsschicht und einer Kombination zweier oder mehrerer der vorstehend genannten Elemente gewählt ist.

9. Leitfähige Folie nach einem der Ansprüche 1 bis 8, wobei die Folie zusätzlich eine die leitfähige Struktur einebnende Schicht und eine Klebschicht aufweist.

10. Leitfähige Folie nach einem der Ansprüche 1 bis 9, wobei das Substrat von der Gruppe bestehend aus Polyethylenterephthalat (PET), Polycarbonat (PC), Polymethylmethacrylat (PMMA), thermoplastischem Polyurethan (TPU) und Glas gewählt ist und bevorzugt ein transparentes Substrat ist.

11. Leitfähige Folie nach einem der Ansprüche 1 bis 10, wobei die leitfähige Folie transparent ist.

12. Verfahren zum Herstellen einer leitfähigen Folie nach einem der Ansprüche 1 bis 11, umfassend die folgenden Schritte:
- das Bereitstellen eines Substrats;
- das Versehen einer Hauptfläche des Substrats mit einer Primerschicht;
- das Aufbringen einer Riss-bildenden Beschichtung auf die Primerschicht und Trocknen der Riss-bildenden Beschichtung, wobei die Beschichtung beim Trocknen zahlreiche Risse in Form eines dichtmaschigen, zusammenhängenden Netzes ausbildet;
- das Aufbringen einer leitfähigen Struktur;
- das Entfernen der mit Rissen versehenen Beschichtung zusammen mit der oberhalb der Beschichtung vorliegenden leitfähigen Struktur, sodass das erhaltene Substrat so beschaffen ist, dass auf seiner mit einer Primerschicht versehenen Hauptfläche die leitfähige Struktur in Form eines dichtmaschigen, zusammenhängenden Netzes mit einer Vielzahl von Öffnungen unterschiedlicher geometrischer Form ausgebildet ist.

13. Verwendung der leitfähigen Folie nach einem der Ansprüche 1 bis 11 als Heizfolie, insbesondere in der Windschutzscheibe eines Fahrzeugs, in sonstigen Fenstern oder in der Gebäudeverglasung, sowie zur Stromeinkopplung ohne sichtbare Zuleitungen, z.B. zur Verwendung in LED-Folien, in Solarzellen, in Smart-Glass-Anwendungen, in OLEDs oder in Touch Panels.
